# EUROPÄISCHE PATENTANMELDUNG

(11) **EP 0 890 988 A2**
(43) Veröffentlichungstag der Anmeldung: **13.01.1999**
(21) Anmeldenummer: 98440142.2
(22) Anmeldetag: 01.07.1998
(51) Int. Cl.: H01L 23/66, H05K 9/00

(54) **In einem Gehäuse angeordnete elektrische Schaltungsanordnung**

(30) Priorität: 11.07.1997 DE 19729671
(71) Anmelder: Alcatel Alsthom Compagnie Generale d'Electricité, 75088 Paris (FR)
(72) Erfinder: Ferling, Dieter, 70199 Stuttgart (DE); Buchali, Fred, Dr., 71336 Waiblingen (DE)
(74) Vertreter: Knecht, Ulrich Karl, Dipl.-Ing.

(57) **Zusammenfassung**

Zum Schutz der in einem Gehäuse angeordneten elektrischen HF-Schaltungen, welche bei Frequenzen von > 1 GHz bis 100 GHz betrieben werden, gegen innere elektromagnetische Störstrahlungen ist, die Gesamtschaltung (1) mit je einer großflächigen elektrische Schwingungen absorbierenden Schicht (3, 4) auf beiden Seiten versehen.

Unterhalb des Schaltungsträgers (1) ist die Schicht (4) aus einem elektrische Schwingungen absorbierenden Werkstoff angeordnet, z.B. Silizium mit mittlerer Leitfähigkeit.
Der Schaltungsträger (1) mit den Bauelementen (5) ist mit einem dielektrischen Werkstoff vergossen, z.B. Silikon-Vergußmasse oder Epoxydharz. Oberhalb des vergossenen Schaltungsträgers (1, 2) ist die Schicht (3) aus einer elektrische Schwingungen absorbierenden Vergußmasse, wie mit Eisenpulver gefülltes Silikon, angeordnet.

## Beschreibung

Die Anmeldung betrifft eine in einem Gehäuse angeordnete elektrische Schaltungsanordnung, bestehend aus einem Schaltungsträger mit darauf angeordneten Bauelementen.

Wenn die Schaltungsanordnung mit Frequenzen über 1 GHz und sogar bis über 100 GHz arbeitet, besteht die Gefahr, daß unerwünschte innere elektromagnetische Wellen erzeugt werden, welche die zuverlässige Funktion von benachbarten Schaltungsteilen stören können.
Um diese nachteiligen gegenseitigen Störungen der benachbarten Schaltungsstufen zu verhindern, sind diese jeweils voneinander getrennt in kleineren Gehäusen angeordnet worden. Durch diese Maßnahme sind die benachbarten Schaltungsstufen zwar wirkungsvoll gegeneinander abgeschirmt, sie ist aber auch mit einem nicht erheblichen Aufwand verbunden. In dem die gesamte Schatltungsanordnung aufnehmenden aus Metall bestehenden Gehäuse sind weitere kleinere Gehäuse anzuordnen, welches außer den dafür aufzuwendenden Kosten auch zu einem höheren Platzbedarf führt. Außerdem erfordert diese Technik eine größere Anzahl von Signalübergängen und Verbindungsstellen.

Das der Erfindung zugrunde liegende technische Problem besteht deshalb darin, die aus elektrischer Schaltungsanordnung mit Gehäuse bestehende Anordnung in der Weise zu gestalten, daß die Einzelabschirmung einer Mehrzahl von Stufen überflüssig ist.
Dieses technische Problem ist erfindungsgemäß dadurch gelöst, daß der Schaltungsträger auf wenigstens einer Seite mit einer großflächigen, elektromagnetische Wellen absorbierenden Schicht versehen ist.
Durch diese Maßnahme wird das Entstehen von Hohlraumresonanzen im Gehäuse und die Ausbreitung parasitärer Wellen in der Schaltung, welche zu Störungen der Schaltungsfunktion führen, verhindert. Außerdem ist der notwendige Aufwand an Bauteilen und Raumbedarf geringer.

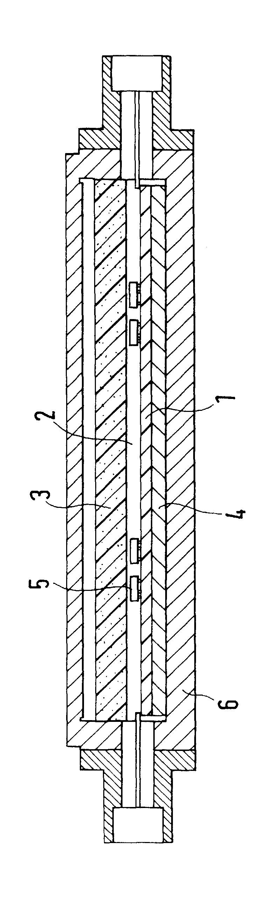

Vorteilhafte Einzelheiten der Erfindung sind in den Ansprüchen 2 bis 4 enthalten, welche nachstehend anhand eines in der Figur gezeigten Ausführungsbeispieles erläutert ist.

In der Figur ist das Gehäuse 6 mit dem darin angeordneten Schaltungsträger 1 zu erkennen, auf dem beispielhaft einige Bauelemente 5 angeordnet sind. Der Schaltungsträger 1 ist mit einem dielektrischen Werkstoff, beispielsweise einer Silikon-Vergußmasse oder einem Epoxyharz vergossen, wodurch die Schicht 2 entstanden ist. Oberhalb des vergossenen Schaltungsträgers 1 ist die Schicht 3 aus einem elektromagnetische Wellen absorbierenden Werkstoff, wie ein mit Eisenpulver oder Kohlenstoff gefülltes Silikon oder Epoxydharz, angeordnet. Unterhalb des Schaltungsträgers 1 kann eine weitere Schicht 4 aus einem elektromagnetische Wellen absorbierenden Werkstoff, wie Silizium mittlerer Leitfähigkeit angeordnet sein. Die Leitfähigkeit dieser Schicht beträgt beispielsweise ca. 3 Ωcm.

## Patentansprüche

1. In einem Gehäuse (6) angeordnete elektrische Schaltungsanordnung, bestehend aus einem Schaltungsträger (1) mit darauf angeordneten Bauelementen (5),
**dadurch gekennzeichnet**, daß
der Schaltungsträger auf wenigstens einer Seite mit einer großflächigen, elektromagnetische Wellen absorbierenden Schicht (3, 4) versehen ist.

2. Schaltungsanordnung nach Anspruch 1,
dadurch gekennzeichnet, daß die die elektromagnetischen Wellen absorbierende Schicht (4) aus Silizium mittlerer Leitfähigkeit besteht.

3. Schaltungsanordnung nach den Ansprüchen 1 und 2,
dadurch gekennzeichnet, daß die die elektromagnetischen Wellen absorbierende Schicht (3) aus einem Werkstoff, wie mit Eisenpulver oder Kohlenstoff gefülltem Silikon oder Epoxydharz besteht.

4. Schaltungsanordnung nach den Ansprüchen 1 bis 3,
dadurch gekennzeichnet, daß der Schaltungsträger (1) mit einem dielektrischen Werkstoff, wie Silikon-Vergußmasse oder Epoxydharz, ganz oder teilweise vergossen ist.
